# EUROPEAN PATENT APPLICATION

(11) **EP 2 981 157 A1**
(43) Date of publication of application: **03.02.2016**
(21) Application number: 14773451.1
(22) Date of filing: 12.03.2014
(51) Int. Cl.: H05K 3/24, H05K 1/02, H05K 3/28

(54) **SUBSTRATE FOR FLEXIBLE PRINTED WIRING BOARD AND METHOD FOR MANUFACTURING SAME, AND FLEXIBLE PRINTED WIRING BOARD USING SAME**

(30) Priority: 25.03.2013 JP 2013063023
(71) Applicant: Sumitomo Electric Industries, Ltd., Chuo-ku Osaka-shi Osaka 541-0041 (JP); Sumitomo Electric Printed Circuits, Inc., Koka-shi Shiga 528-0068 (JP)
(72) Inventor: YONEZAWA, Takayuki, Osaka-shi Osaka 554-0024 (JP); KAIMORI, Shingo, Osaka-shi Osaka 554-0024 (JP); SUGAWARA, Jun, Osaka-shi Osaka 554-0024 (JP); ASAI, Shogo, Koka-shi Shiga 528-0068 (JP); UCHITA, Yoshifumi, Koka-shi Shiga 528-0068 (JP)
(74) Representative: Boult Wade Tennant
(86) International application number: PCT/JP2014/056400
(87) International publication number: WO 2014/156621

(57) **Abstract**

It is an object of the present invention to provide a substrate for a flexible printed circuit board having high long-term heat resistance and oil resistance, a method for manufacturing the same, and a flexible printed circuit board using the same. A flexible printed circuit board according to the present invention includes an insulating flexible base film, a conductive pattern made of copper disposed on a surface side of the base film, and a protective film disposed on a surface side of the conductive pattern with an adhesive layer therebetween. The flexible printed circuit board further includes a shielding layer disposed on a surface of the conductive pattern, the shielding layer preventing leakage of copper or permeation of components reactive with copper. The main component of the shielding layer may be nickel (Ni), tin (Sn), or aluminum (Al). The shielding layer may be formed by a plating on the surface of the conductive pattern. The average thickness of the shielding layer may be 0.01 to 6.0 µm.

## Description

### Technical Field

The present invention relates to a substrate for a flexible printed circuit board, a method for manufacturing the same, and a flexible printed circuit board using the same.

### Background Art

In recent years, with the computerization of automotive systems, the number of engine control units mounted on automobiles has been increasing. Furthermore, as needs increase for energy saving and weight reduction in automobiles, automobiles are increasingly required to be more compact. As a result, there are increased demands for flexible printed circuit boards. A flexible printed circuit board is fabricated, for example, by attaching copper foil to a surface side of a polyimide resin film serving as a base film, forming a conductive pattern on the copper foil by etching or the like, and then attaching a protective film so as to cover the surface of the copper foil with an adhesive layer therebetween. The protective film is composed of a polyimide resin or the like and has a function of oxidation inhibition, insulation, and protection of the conductive pattern.

When flexible printed circuit boards are used around engines and transmissions, since the ambient temperature is high, long-term heat resistance at 150°C is required. Moreover, when flexible printed circuit boards are used around engines, in addition to the long-term heat resistance, oil resistance is required. However, in existing flexible printed circuit boards, long-term heat resistance and oil resistance are insufficient, and the protective film is likely to peel off the base film, which is disadvantageous.

Therefore, studies have been performed on adhesives having improved long-term heat resistance (refer to Japanese Unexamined Patent Application Publication No. 2011-190425 and Japanese Unexamined Patent Application Publication No. 2003-213241).

### Citation List

### Patent Literature

PTL 1: Japanese Unexamined Patent Application Publication No. 2011-190425
PTL 2: Japanese Unexamined Patent Application Publication No. 2003-213241

### Summary of Invention

### Technical Problem

However, even in the adhesives of Japanese Unexamined Patent Application Publication No. 2011-190425 and Japanese Unexamined Patent Application Publication No. 2003-213241, it is not possible to obtain sufficient long-term heat resistance. The present invention has been achieved under these circumstances, and it is an object of the invention to provide a substrate for a flexible printed circuit board having high long-term heat resistance and oil resistance, a method for manufacturing the same, and a flexible printed circuit board using the same.

### Solution to Problem

One of the reasons for the phenomenon of the protective film being likely to peel off under the high temperature of 150°C, such as around engines and transmissions, is oxidation degradation of the adhesive itself. Other reasons are believed to be the following:
(1) Since copper diffuses from the conductive pattern of copper foil into the adhesive, the protective film becomes likely to peel off.
(2) Copper becomes oxidized because the conductive pattern of copper foil is placed under a high-temperature condition, and brittle portions composed of copper oxide are formed at the interface with the adhesive layer.
(3) Because of permeation of components reactive with copper, such as sulfur, attributable to oil mist and the like around engines, transmissions, and the like, the components reactive with copper react with copper, and brittle portions composed of copper sulfide or the like are formed at the interface with the adhesive layer.

On the basis of the above-described probable causes (1), (2), and (3), the present inventors have conducted studies on how to prevent diffusion of copper and formation of brittle portions.

A substrate for a flexible printed circuit board according to a first embodiment of the present invention which has been achieved in order to solve the problem described above is characterized by including an insulating flexible base film, a conductive pattern made of copper disposed on one or both surfaces of the base film, and a shielding layer disposed on a surface of the conductive pattern, the shielding layer preventing leakage of copper or permeation of components reactive with copper.

Furthermore, a substrate for a flexible printed circuit board according to a second embodiment of the present invention which has been achieved in order to solve the problem described above is characterized by including an insulating flexible base film, a conductive pattern made of copper disposed on one or both surfaces of the base film with an adhesive layer for the base film therebetween, and a shielding layer on a surface of the conductive pattern on the side in contact with the adhesive layer for the base film, the shielding layer preventing leakage of copper or permeation of components reactive with copper.

Furthermore, in another embodiment, the substrate for a flexible printed circuit board according to the second embodiment of the present invention is characterized by further including a shielding layer on another surface of the conductive pattern, the shielding layer preventing leakage of copper or permeation of components reactive with copper.

Furthermore, a flexible printed circuit board according to the present invention which has been achieved in order to solve the problem described above includes the substrate for a flexible printed circuit board according to the present invention, and a protective film disposed on a surface side of the conductive pattern with an adhesive layer therebetween.

In each of the substrates for a flexible printed circuit board according to the embodiments of the present invention described above, the shielding layer prevents leakage of copper from the conductive pattern so as to suppress diffusion of copper into the periphery, and prevents permeation of components reactive with copper, such as oxygen and sulfur, so as to suppress reactions between copper and components reactive with copper, thus reducing the likelihood that brittle portions will be formed. Therefore, the substrate can be suitably used as a substrate for a flexible printed circuit board having long-term heat resistance and oil resistance.

Furthermore, the flexible printed circuit board according to the present invention includes the substrate for a flexible printed circuit board according to any of the embodiments of the present invention. In the flexible printed circuit board, since the shielding layer prevents leakage of copper from the conductive pattern, diffusion of copper into the adhesive is suppressed, thus reducing the likelihood that the protective film will peel off. Furthermore, in the flexible printed circuit board, since the shielding layer prevents permeation of components reactive with copper, such as oxygen and sulfur, reactions between copper and components reactive with copper are suppressed, and there is a reduced likelihood that brittle portions will be formed. Consequently, the long-term heat resistance and oil resistance of the flexible printed circuit board increase. The term "leakage of copper" means that copper in the conductive pattern moves to the periphery of the conductive pattern, and examples thereof include diffusion of copper into the adhesive. Furthermore, the term "component reactive with copper" means a component that forms a compound with copper, and examples thereof include oxygen and sulfur.

Furthermore, after the flexible printed circuit board according to the present invention is left to stand in automatic transmission fluid (ATF) oil mist at 150°C for 1,000 hours, the peel strength between the protective film and the conductive pattern is preferably 2 N/cm or more. When the peel strength is 2 N/cm or more, even if the flexible printed circuit board is used around engines and transmissions, there is a reduced likelihood that the peel-off of the protective film will cause insulation failure.

Furthermore, after the flexible printed circuit board according to the present invention is left to stand in ATF oil at 150°C for 1,000 hours, the peel strength between the protective film and the conductive pattern is preferably 2 N/cm or more. When the peel strength is 2 N/cm or more, even if the flexible printed circuit board is used around engines and transmissions, there is a reduced likelihood that the peel-off of the protective film will cause insulation failure.

Furthermore, after the flexible printed circuit board according to the present invention is subjected to heat treatment in air at 150°C for 1,000 hours, the peel strength between the protective film and the conductive pattern is preferably 70% or more of the peel strength before the heat treatment. When the peel strength after the heat treatment is 70% or more, even if the flexible printed circuit board is used at a high temperature of 150°C, there is a reduced likelihood that the peel-off of the protective film will cause insulation failure.

The term "peel strength" refers to a value measured in accordance with JIS-C-6481, and means a value measured by changing the peeling direction from 90° to 180°. The peel strength can be measured, for example, using, as a testing machine, "Autograph precision universal testing machine (AG-IS) manufactured by Shimadzu Corporation". Furthermore, the peel strength between the protective film and the conductive pattern refers to peel strength between the protective film and an unpatterned conductor (e.g., copper foil).

The main component of the shielding layer is preferably nickel (Ni), tin (Sn), or aluminum (Al). When the main component of the shielding layer is Ni, Sn, or Al, it is possible to more reliably prevent leakage of copper from the conductive pattern and permeation of components reactive with copper into the conductive pattern. The term "main component" refers to a component whose content by mass is highest among all components contained.

The shielding layer can be formed by a plating of nickel (Ni) or tin (Sn), or vapor deposition or the like of aluminum (Al). Preferably, the shielding layer is formed by a plating on the surface of the conductive pattern. By forming the shielding layer by plating, it is possible to form a shielding layer having an appropriate thickness and high shielding capability at low cost. Therefore, the shielding layer is more preferably composed of Ni or Sn which can be easily formed by plating.

In order to form the shielding layer by plating, for example, it may be possible to employ a method in which, after plating is performed on copper, a conductive pattern is formed. However, it is preferable to use a method in which, after a conductive pattern of copper is formed, plating is performed on the conductive pattern. By employing the method in which plating is performed after the formation of the conductive pattern, plating is performed not only on the surface but also on the side of the conductive pattern. That is, the shielding layer can be formed not only on the surface but also on the side of the conductive pattern. When the shielding layer is formed also on the side of the conductive pattern, the long-term heat resistance and oil resistance of the protective film are further improved.

The average thickness of the shielding layer is preferably 0.01 to 6.0 µm. When the average thickness of the shielding layer is in the range described above, it is possible to easily and appropriately prevent leakage of copper and permeation of components reactive with copper using the shielding layer.

The main component of the adhesive constituting the adhesive layer is preferably a polyimide resin. When the main component of the adhesive is a polyimide resin, even if the flexible printed circuit board is placed under high-temperature conditions for a long time, it is possible to suppress a decrease in the adhesion force of the adhesive due to oxidation degradation, and long-term heat resistance of the adhesive is increased. The term "main component" refers to a component whose content by mass is highest among all components contained.

Furthermore, a method for manufacturing a substrate for a flexible printed circuit board according to the present invention which has been achieved in order to solve the problem described above includes a step of forming a substrate which includes an insulating flexible base film, a conductive pattern made of copper disposed on a surface side of the base film, and a shielding layer disposed on a surface of the conductive pattern, the shielding layer preventing leakage of copper or permeation of components reactive with copper.

In this manufacturing method, it is possible to manufacture a substrate for a flexible printed circuit board which has high long-term heat resistance and oil resistance, in which the protective film is unlikely to peel off the base film even if placed in a high-temperature atmosphere of 150°C or in oil or oil mist at 150°C for a long time. Advantageous Effects of Invention

In a substrate for a flexible printed circuit board, a method for manufacturing the same, and a flexible printed circuit board using the same, it is possible to increase long-term heat resistance and oil resistance.

### Brief Description of Drawings

[Fig. 1] Figure 1 is a schematic end view showing a substrate for a flexible printed circuit board according to an embodiment of the present invention.
[Fig. 2] Figure 2 is a schematic end view showing a substrate for a flexible printed circuit board according to another embodiment of the present invention.
[Fig. 3] Figure 3 is a schematic end view showing a substrate for a flexible printed circuit board according to still another embodiment of the present invention.
[Fig. 4] Figure 4 is a schematic end view showing a flexible printed circuit board according to an embodiment of the present invention.
[Fig. 5] Figure 5 includes schematic end views illustrating a method for manufacturing the flexible printed circuit board shown in Fig. 4.
[Fig. 6] Figure 6 is a schematic end view showing a flexible printed circuit board in Example 1 of the present invention.
[Fig. 7] Figure 7 is a configuration diagram of a hermetically sealed container used in examples of the present invention.

### Description of Embodiments

Embodiments of a substrate for a flexible printed circuit board and a flexible printed circuit board using the same according to the present invention will be described in detail below with reference to the drawings.

### [Substrate for flexible printed circuit board]

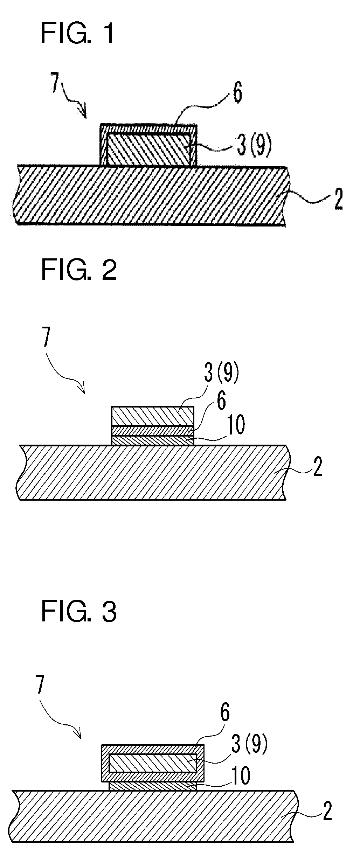

Figure 1 is a schematic end view showing a substrate for a flexible printed circuit board according to an embodiment of the present invention. A substrate 7 for a flexible printed circuit board includes an insulating flexible base film 2, a conductive pattern 3 made of copper disposed on a surface side of the base film 2, and a shielding layer 6 disposed on a surface of the conductive pattern 3, the shielding layer 6 preventing leakage of copper or permeation of components reactive with copper.

### <Base film>

The base film 2 is formed of an insulating flexible sheet-like member, and specifically, a resin film can be used. As the main component of the resin film, for example, a polyimide resin, a polyethylene terephthalate resin, a liquid crystal polymer (LCP), a fluororesin, or the like can be used. From the viewpoint of flexibility and strength, a polyimide resin is preferable. Furthermore, as secondary components of the resin film, for example, another resin, a weathering stabilizer, an antistatic agent, and the like may be appropriately mixed.

The average thickness of the base film 2 is not particularly limited, but can be set, for example, at 5 to 100 µm.

### <Conductive pattern>

The conductive pattern 3 is formed into a desired planar shape (pattern) by etching a copper foil 9 disposed on the base film 2. The lower limit of the average thickness of the conductive pattern 3 is not particularly limited, but is preferably 2 µm, and more preferably 5 µm. Furthermore, the upper limit of the average thickness of the conductive pattern 3 is not particularly limited, but is preferably 100 µm, and more preferably 75 µm. When the average thickness of the conductive pattern 3 is less than the lower limit, there is a concern that conductivity may be insufficient. When the average thickness of the conductive pattern 3 is more than the upper limit, there is a concern that the requirement for reduction in thickness may not be satisfied.

### <Shielding layer>

The shielding layer 6 is a layer that is disposed on the surface and the side (etched cross section) of the conductive pattern 3 as described above. The material for the shielding layer 6 is not particularly limited as long as it can prevent leakage of copper from the conductive pattern 3 or permeation of components reactive with copper into the conductive pattern 3. Examples that can be used include a metal, a resin, a ceramic, and a mixture thereof. Among these, Ni, Sn, or Al is preferably used. When the main component of the shielding layer 6 is Ni, Sn, or Al, it is possible to more reliably prevent leakage of copper from the conductive pattern 3 and permeation of components reactive with copper into the conductive pattern 3.

The shielding layer 6 of Ni or Sn can be formed by plating, and the shielding layer 6 of Al can be formed by vapor deposition. Furthermore, the shielding layer 6 can be formed by a chemical vapor deposition method, such as thermal CVD or plasma CVD; a physical vapor deposition method, such as sputtering or ion plating; a thermal spraying method, such as gas thermal spraying or electric thermal spraying; or the like. In particular, preferably, the shielding layer 6 is formed by plating. By forming the shielding layer 6 by plating, it is possible to form a shielding layer 6 having an appropriate thickness and high shielding capability at low cost. Therefore, the shielding layer 6 is more preferably composed of Ni or Sn which can be easily formed by plating. In particular, since the flexible printed circuit board 1 is typically subjected to a high-temperature process, such as soldering with a reflow oven at the time of manufacturing, and is assumed to be used at a high temperature of 150°C, Ni that has excellent heat resistance is more preferable. As described above, after the conductive pattern is formed into a desired planar shape, the shielding layer 6 is formed by plating.

The lower limit of the average thickness of the shielding layer 6 is not particularly limited, but is preferably 0.01 µm, more preferably 0.03 µm, and still more preferably 0.05 µm. Furthermore, the upper limit of the average thickness of the shielding layer 6 is not particularly limited, but is preferably 6.0 µm, more preferably 1.0 µm, and still more preferably 0.5 µm. When the average thickness of the shielding layer 6 is less than the lower limit, there is a concern that prevention of leakage of copper and permeation of components reactive with copper may be insufficient. Even when the average thickness of the shielding layer 6 is more than the upper limit, it is not possible to expect a further effect of preventing leakage of copper and permeation of components reactive with copper, and there is a concern that costs may be higher.

Figure 2 is a schematic end view showing a substrate for a flexible printed circuit board according to another embodiment of the present invention. A substrate 7 for a flexible printed circuit board includes an insulating flexible base film 2, a conductive pattern 3 made of copper disposed on a surface side of the base film 2 with an adhesive layer 10 for the base film therebetween, and a shielding layer 6 disposed on a surface of the conductive pattern 3 on the side in contact with the adhesive layer for the base film 10, the shielding layer 6 preventing leakage of copper or permeation of components reactive with copper. The constituent materials, thickness, and the like of the base film 2, the conductive pattern 3, and the shielding layer 6 are the same as the constituent materials, thickness, and the like of the base film, the conductive pattern, and the shielding layer of the substrate for a flexible printed circuit board according to the embodiment of the present invention described above. Furthermore, the constituent material for the adhesive layer 10 for the base film is the same as that used for the adhesive layer of a flexible printed circuit board according to the present invention which will be described later. Furthermore, the lower limit of the average thickness of the adhesive layer 10 for the base film is not particularly limited, but is preferably 3 µm, and more preferably 5 µm. Furthermore, the upper limit of the average thickness of the adhesive layer 10 for the base film is not particularly limited, but is preferably 50 µm, and more preferably 20 µm. When the average thickness is less than the lower limit, there is a concern that the peel strength may be insufficient. Furthermore, when the average thickness is more than the upper limit, there is a concern that the flexibility of the substrate for a flexible printed circuit board 7 may be impaired.

Figure 3 is a schematic end view showing a substrate for a flexible printed circuit board according to another embodiment of the present invention. A substrate 7 for a flexible printed circuit board includes an insulating flexible base film 2, a conductive pattern 3 made of copper disposed on a surface side of the base film 2 with an adhesive layer 10 for the base film therebetween, and a shielding layer 6 disposed on both surfaces of the conductive pattern 3, the shielding layer 6 preventing leakage of copper or permeation of components reactive with copper. The constituent materials, thickness, and the like of the base film 2, the conductive pattern 3, the shielding layer 6, and the adhesive layer 10 for the base film are the same as those of the substrate for a flexible printed circuit board described above.

### [Flexible printed circuit board]

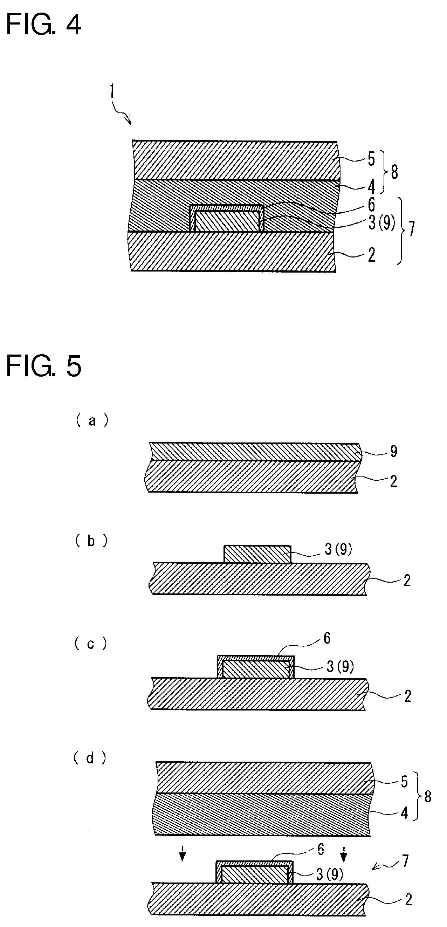

Figure 4 is a schematic end view showing a flexible printed circuit board according to an embodiment of the present invention. A flexible printed circuit board 1 includes an insulating flexible base film 2, a conductive pattern 3 made of copper disposed on a surface side of the base film 2, a protective film 5 disposed on a surface side of the conductive pattern 3 with an adhesive layer 4 therebetween, and a shielding layer 6 disposed on a surface of the conductive pattern 3, the shielding layer 6 preventing leakage of copper or permeation of components reactive with copper. Specifically, the flexible printed circuit board 1 includes a substrate 7 including the base film 2, the conductive pattern 3, and the shielding layer 6, and a cover lay film 8 including the protective film 5 and the adhesive layer 4. Note that the protective film 5 is not bonded to areas where lands to be electrically connected to other parts are formed in the conductive pattern 3. The constituent materials, thickness, and the like of the base film 2, the conductive pattern 3, and the shielding layer 6 are the same as the constituent materials, thickness, and the like of the base film, the conductive pattern, and the shielding layer of the substrate for a flexible printed circuit board according to the present invention described above.

### <Adhesive>

The adhesive layer 4 is disposed on the rear surface of the protective film 5, and bonds the protective film 5 to the substrate 7 as described above. Examples of the main component of the adhesive constituting the adhesive layer 4 include a polyimide resin, an epoxy resin, an alkyd resin, a urethane resin, a phenolic resin, a melamine resin, an acrylic resin, a polyamide resin, a polyethylene resin, a polystyrene resin, a polypropylene resin, a polyester resin, a vinyl acetate resin, and rubber. In particular, the main component of the adhesive is preferably a polyimide resin, and more preferably a siloxane-modified polyimide resin. By using a polyimide resin as the main component of the adhesive, even when placed under high-temperature conditions for a long time, it is possible to suppress a decrease in the adhesion force of the adhesive due to oxidation degradation, and the long-term heat resistance of the adhesive is increased. Furthermore, by using a flexible siloxane-modified polyimide resin, improvement in adhesion force can be anticipated. Furthermore, as secondary components of the adhesive, for example, a tackifier, a plasticizer, a curing agent, and the like may be appropriately mixed.

The lower limit of the average thickness of the adhesive layer 4 is not particularly limited, but is preferably 12.5 µm, and more preferably 15 µm. Furthermore, the upper limit of the average thickness of the adhesive layer 4 is not particularly limited, but is preferably 100 µm, and more preferably 75 µm. When the average thickness of the adhesive layer 4 is less than the lower limit, there is a concern that the peel strength may be insufficient. Furthermore, when the average thickness of the adhesive layer 4 is more than the upper limit, there is a concern that the flexibility of the flexible printed circuit board 1 may be impaired.

### <Protective film>

As the protective film 5, a resin film is commonly used, and examples of the main component thereof include a polyimide resin, an epoxy resin, a phenolic resin, an acrylic resin, a polyester resin, and a polyethylene terephthalate resin. In particular, from the viewpoint of heat resistance, a polyimide resin is preferable. Furthermore, the secondary components of the protective film 5 are the same as those of the base film 2.

The lower limit of the average thickness of the protective film 5 is not particularly limited, but is preferably 3 µm, and more preferably 10 µm. Furthermore, the upper limit of the average thickness of the protective film 5 is not particularly limited, but is preferably 500 µm, and more preferably 150 µm. When the average thickness of the protective film 5 is less than the lower limit, there is a concern that an insulating property may be insufficient. Furthermore, when the average thickness of the protective film 5 is more than the upper limit, there is a concern that the flexibility of the flexible printed circuit board 1 may be impaired.

### <Peel strength>

The peel strength between the protective film 5 and the conductive pattern 3 is preferably 3 (N/cm) or more, and more preferably 5 (N/cm) or more, after the flexible printed circuit board 1 is subjected to heat treatment in air at 150°C for 1,000 hours. When the peel strength after the heat treatment is less than the lower limit described above, there is a concern that the protective film 5 may peel off in an operating environment of an automobile or the like. Furthermore, the peel strength between the protective film 5 and the conductive pattern 3 is preferably 3 (N/cm) or more, and more preferably 5 (N/cm) or more, before heat treatment in air at 150°C for 1,000 hours. When the peel strength before the heat treatment is less than the lower limit described above, there is a concern that the protective film 5 may peel off during the manufacture of the flexible printed circuit board 1. Furthermore, the peel strength between the protective film 5 and the conductive pattern 3 after the heat treatment is preferably 70% or more, and more preferably 80% or more, of the peel strength before the heat treatment. When the peel strength is less than the lower limit described above, there is a concern that the protective film 5 may peel off in an operating environment around engines, transmissions, and the like. Furthermore, the peel strength after the heat treatment is preferably 150% or less of the peel strength before the heat treatment.

Furthermore, after the flexible printed circuit board 1 is left to stand in automatic transmission fluid (ATF) oil at 150°C for 1,000 hours, the peel strength between the protective film 5 and the conductive pattern 3 is preferably 2 (N/cm) or more. When the peel strength is 2 (N/cm) or more, even if the flexible printed circuit board is used around engines and transmissions, there is a reduced likelihood that the peel-off of the protective film will cause insulation failure. Furthermore, after the flexible printed circuit board 1 is left to stand in ATF oil mist at 150°C for 1,000 hours, the peel strength between the protective film 5 and the conductive pattern 3 is preferably 2 (N/cm) or more. When the peel strength is 2 (N/cm) or more, even if the flexible printed circuit board is used around engines and transmissions, there is a reduced likelihood that the peel-off of the protective film will cause insulation failure.

### [Method for manufacturing substrate for flexible printed circuit board and flexible printed circuit board using the same]

A method for manufacturing a substrate for a flexible printed circuit board and a flexible printed circuit board 1 using the same will be described with reference to Fig. 5. The method for manufacturing the flexible printed circuit board 1 includes manufacturing a substrate for a flexible printed circuit board, which is a step of forming a substrate 7 including an insulating flexible base film 2, a conductive pattern 3 made of copper disposed on a surface side of the base film 2, and a shielding layer 6 disposed on a surface of the conductive pattern 3, the shielding layer 6 preventing leakage of copper or permeation of components reactive with copper, and a step of stacking a protective film 5 on a surface side of the substrate 7 with an adhesive layer 4 therebetween, using the substrate for a flexible printed circuit board. In this embodiment, a case where the shielding layer 6 is formed by Ni plating will be described.

### <Substrate formation step>

The substrate formation step includes a step of forming a conductive pattern 3 having a predetermined planar shape in which a base film 2 on which a copper foil 9 (copper film) is disposed is used, as shown in Fig. 5(a), and the copper foil 9 is etched; and a step of forming a shielding layer 6 by plating the conductive pattern 3 thus formed.

Examples of the method for disposing the copper foil 9 on the base film 2 that can be used include an adhesion method in which the copper foil 9 is attached using an adhesive; a casting method of applying a resin composition, which is a material for the base film 2, onto the copper foil 9; a sputtering/plating method in which a metal layer is formed by electrolytic plating on a thin conductive layer (seed layer) with a thickness of several nanometers formed by sputtering or a vapor deposition method on the base film 2, and a lamination method in which a metal foil is attached by hot pressing.

Furthermore, in the conductive pattern formation step, a resist film having a shape corresponding to an electrical circuit to be formed is disposed on the surface of the copper foil 9, and the conductive pattern 3 is formed by etching.

Furthermore, in the shielding layer formation step, by plating the conductive pattern 3 with Ni, the shielding layer 6 is formed. By this plating treatment, Ni plating is performed not only on the surface of the conductive pattern 3, but also on the side (etched surface) of the conductive pattern 3. In this plating treatment, electrolytic plating and electroless plating can be used. When electroless plating is used, the thickness of the shielding layer 6 can be made uniform easily and reliably. On the other hand, by using electrolytic plating, a dense shielding layer 6 can be formed, and the shielding layer 6 can be easily disposed on the side of the conductive pattern 3. In particular, electroless plating in which a thin shielding layer 6 with a uniform thickness can be formed by plating with inexpensive equipment is preferably used.

### <Protective film stacking step>

In the protective film stacking step, as shown in Fig. 5(d), a cover lay film 8 in which the adhesive layer 4 is disposed on the rear surface of the protective film 5 is attached to the substrate 7 such that the adhesive layer 4 side faces the shielding layer 6 and the base film 2. Note that the protective film 5 is not attached to areas where lands are to be formed in the conductive pattern 3. Subsequently, the substrate 7 to which the cover lay film 8 is attached is heated. The heating temperature is preferably 120°C to 200°C, and the heating time is preferably 1 to 60 minutes. By setting the heating temperature and the heating time in the ranges described above, the adhesiveness of the adhesive layer 4 can be effectively exhibited, and also it is possible to suppress deterioration of the base film 2 and the like. The heating method is not particularly limited, and for example, heating can be performed using a heating device, such as a hot press, an oven, or a hot plate. Furthermore, in order to improve adhesiveness, preferably, the base film 2 and the protective film 5 are compressed during heating.

In the flexible printed circuit board 1, even if placed in an atmosphere of 150°C or in oil or oil mist at 150°C, the shielding layer 6 prevents leakage of copper from the conductive pattern 3. Therefore, diffusion of copper into the adhesive layer 4 is prevented, and there is a reduced likelihood that the protective film 5 will peel off. Furthermore, since the shielding layer 6 prevents permeation of components reactive with copper, such as oxygen and sulfur attributable to oil mist, reactions between copper in the conductive pattern 3 and components reactive with copper are suppressed, and formation of brittle portions is inhibited. Therefore, the long-term heat resistance and oil resistance of the flexible printed circuit board 1 are increased, and even if placed in an atmosphere of 150°C or in oil or oil mist at 150°C for a long time, the peel-off of the protective film 5 from the base film 2 is markedly suppressed.

### [Other embodiments]

In the embodiments described above, the flexible printed circuit board 1 is a single-sided printed wiring board. However, the flexible printed circuit board 1 may be a double-sided printed wiring board or a multilayer printed wiring board including a plurality of base films. In such embodiments, the long-term heat resistance and oil resistance of the flexible printed circuit board 1 are increased as in the embodiments described above.

Furthermore, in the embodiments described above, after the conductive pattern 3 is formed by etching the copper foil 9 disposed on the surface of the base film 2, the shielding layer 6 is formed by plating. However, the conductive pattern 3 may be formed by etching after the copper foil 9 is plated. That is, in the substrate formation step, the conductive pattern formation step can be performed after the shielding layer formation step. Note that by performing the shielding layer formation step after the conductive pattern formation step, the shielding layer 6 can be disposed not only on the surface of the conductive pattern 3, but also on the side of the conductive pattern 3, and the long-term heat resistance and oil resistance of the protective film can be further increased.

In the embodiments described above, after the copper foil 9 (conductive pattern-forming material) is disposed on the base film 2, formation of the conductive pattern 3 and formation of the shielding layer 6 are performed. However, the copper foil 9 (conductive pattern-forming material) can be disposed on the base film 2 after formation of the conductive pattern 3 or formation of the shielding layer 6. Specifically, for example, a method may be used in which a conductive pattern 3 having a desired planar shape is formed by etching a copper foil 9 before being disposed on a base film 2, and the conductive pattern 3 is disposed on the base film 2. That is, a copper film stacking step can be performed after the conductive pattern formation step. In this case, the shielding layer formation step can be performed before the conductive pattern formation step, or after the conductive pattern formation step and before the copper film stacking step, or after the copper film stacking step.

Furthermore, the shielding layer 6 and the adhesive layer 4 may not be placed adjacent to each other, and another layer, for example, an insulating layer made of a resin, may be provided between the shielding layer 6 and the adhesive layer 4. Since the shielding layer 6 prevents leakage of copper from the conductive pattern 3 and permeation of components reactive with copper into the conductive pattern 3, even when the shielding layer 6 and the adhesive layer 4 are not placed adjacent to each other in such a manner, the advantageous effects of the present invention can be obtained, and the protective film 5 is unlikely to peel off the base film 2.

Furthermore, in the embodiments described above, the flexible printed circuit board including the substrate 7 and the cover lay film 8 has been described. However, the present invention is not limited thereto. That is, without using a cover lay film 8, such as the one in the embodiments described above, an adhesive may be applied to the surface of a substrate 7, such as the one in the embodiments described above, and a protective film 5 may be disposed on the applied adhesive.

### EXAMPLES

The present invention will be described more in detail on the basis of examples. However, it is to be understood that the present invention is not limited to the examples. In the examples and comparative examples described below, flexible printed circuit boards having adhesives with various type and shielding layers with various structures were fabricated, and peel strength was measured before and after heat treatment under 3 types of heat treatment conditions in which the heat treatment atmosphere was varied.

### [Example 1]

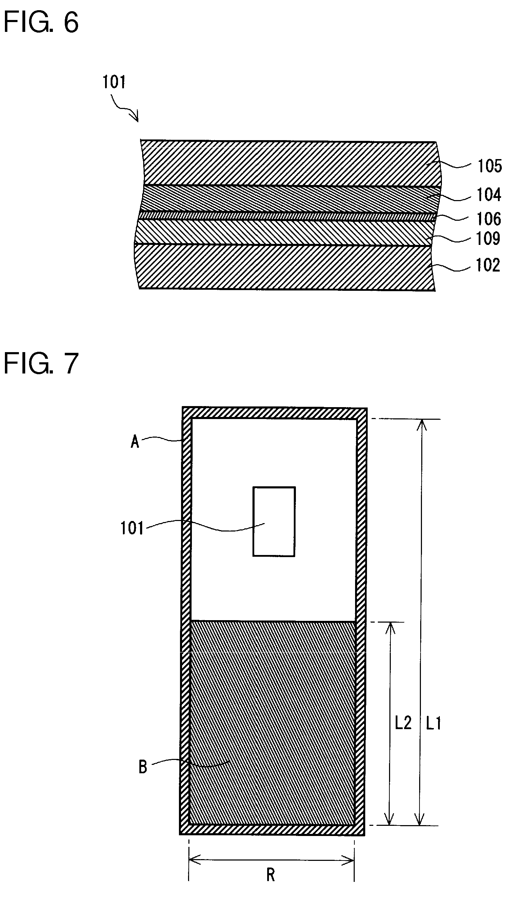

Figure 6 shows the structure of a flexible printed circuit board 101 in Example 1. The flexible printed circuit board 101 serving as a sample was fabricated in the following manner. A copper foil 109 was bonded to and disposed on the surface of a base film 102, a shielding layer 106 composed of Ni was formed by electroless plating on the surface of the copper foil 109. A protective film 105 was bonded to the shielding layer 106 with an adhesive layer 104 therebetween under the conditions described below, and thereby, a sample was obtained. In this example, the copper foil 109 disposed was used as a conductive pattern.

The conditions, such as the material and size, of the components of the flexible printed circuit board 101 are shown below.
a. Main component of base film 102: polyimide resin
b. Thickness of base film 102 (µm): 25 µm
c. Thickness of copper foil 109 (µm): 35 µm
d. Thickness of shielding layer 106 (Ni plating) (µm): 0.1 µm
e. Main component of adhesive constituting adhesive layer 104: polyimide resin
f. Thickness of adhesive layer 104 (µm): 30 to 40 µm
g. Main component of protective film 105: polyimide resin
h. Thickness of protective film 105 (µm): 25 µm
i. Bonding conditions of protective film 105:
   (1) Pressure: 3 MPa
   (2) Heating temperature: 180°C
   (3) Time: 45 minutes

### [Example 2]

Among the conditions of Example 1, the material for the adhesive layer 104 was changed as described below, and the other conditions were the same as those of Example 1. a. Adhesive constituting adhesive layer 104: polyimide resin (main component) and polyamide resin contained.

### [Example 3]

Among the conditions of Example 1, the material for the adhesive layer 104 was changed as described below, and the other conditions were the same as those of Example 1. a. Main component of adhesive constituting adhesive layer 104: acrylic resin

### [Example 4]

Among the conditions of Example 1, instead of the Ni plating shielding layer, a Sn plating shielding layer was formed by electroless plating. The thickness (µm) of the Sn plating was set at 0.7 µm. The other conditions were the same as those of Example 1.

### [Comparative Example 1]

Among the conditions of Example 1, no shielding layer 106 was used without performing Ni plating on the copper foil 109. The other conditions were the same as those of Example 1.

### [Comparative Example 2]

Among the conditions of Example 2, no shielding layer 106 was used without performing Ni plating on the copper foil 109. The other conditions were the same as those of Example 2.

### [Comparative Example 3]

Among the conditions of Example 3, no shielding layer 106 was used without performing Ni plating on the copper foil 109. The other conditions were the same as those of Example 3.

### [Testing]

Testing was performed on the flexible printed circuit boards of the examples and the comparative examples under the following conditions.

### <Heat treatment conditions>

### (1) Heat treatment conditions 1

The flexible printed circuit boards were each heated in air at 150°C for 1,000 hours.

### (2) Heat treatment conditions 2

The flexible printed circuit boards were each immersed in ATF oil "Toyota genuine auto fluid (WS), manufactured by Toyota Motor Corporation" and heated at 150°C for 1,000 hours.

### (3) Heat treatment conditions 3

In a hermetically sealed container A with an inside diameter R of 30 mm and a height L1 of 300 mm shown in Fig. 7, ATF oil B, which was the same as that used under heat treatment conditions 2, was placed at a depth L2 of 140 mm and heated to 150°C. The flexible printed circuit boards were each heated in oil mist in the upper portion of the container for 1,000 hours. The temperature in the upper portion of the container was about 150°C, and the oil mist concentration in the container was a saturated concentration at 150°C.

### <Method for measuring peel strength>

The value measured in accordance with JIS-C-6481 by changing the peeling direction from 90° to 180° was defined as the peel strength. As a testing machine, "Autograph precision universal testing machine (AG-IS) manufactured by Shimadzu Corporation" was used. In the measurement of the peel strength, with the base film 102, the copper foil 109, and the shielding layer 106 being held together by a clip on one terminal, and the protective film 105 being held by a clip on another terminal, peel strength was measured.

The results of the examples and the comparative examples are shown in Table.

**[Table]**

| | Heat treatment conditions 1 | | Heat treatment conditions 2 | | Heat treatment conditions 3 | |
|---|---|---|---|---|---|---|
| | Peel strength before heat treatment | Peel strength after heat treatment | Peel strength before heat treatment | Peel strength after heat treatment | Peel strength before heat treatment | Peel strength after heat treatment |
| | (N/cm) | (N/cm) | (N/cm) | (N/cm) | (N/cm) | (N/cm) |
| Example 1 | 6 | 8 | 10 | 6 | 10 | 6 |
| Example 2 | 10 | 11 | 10 | 5 | - | - |
| Example 3 | 15 | 1 | - | - | - | - |
| Example 4 | 14 | 14 | - | - | - | - |
| Comparative Example 1 | 6 | 4 | 10 | <1 | 10 | < 1 |
| Comparative Example 2 | 10 | 1 to 2 | 10 | <1 | - | - |
| Comparative Example 3 | 15 | 0 | - | - | - | - |

Under the heat treatment conditions 1 in which the heat treatment atmosphere is air, when comparison is made between the examples in which Ni plating is performed and the comparative examples in which Ni plating is not performed and between the flexible printed circuit boards using the same adhesive (comparison between Example 1 and Comparative Example 1, comparison between Example 2 and Comparative Example 2, and comparison between Example 3 and Comparative Example 3), in the case of any of the adhesives, the peel strength before heat treatment of the example is at the same level as that of the comparative example, but the peel strength after heat treatment of the example is higher than that of the comparative example. Furthermore, when comparison is made between Example 4 in which Sn plating is performed and Comparative Example 3 in which Sn plating is not performed, the same results are obtained. The reason for this is believed to be that diffusion of copper into the adhesive layer is suppressed and oxidation of the copper foil is prevented by the shielding layer.

In particular, in Example 1, Example 2, and Example 4 in which the main component of the adhesive layer is a polyimide resin, the peel strength after heat treatment is high. The reason for this is believed to be that since the main component of the adhesive is a polyimide resin which has high heat resistance, in combination with the effect of the shielding layer, the heat resistance of the flexible printed circuit board is further increased. Furthermore, in Example 1, Example 2, and Example 4, the peel strength after heat treatment is 100% or more of the peel strength before heat treatment, thus indicating high heat resistance. Regarding Example 3 and Comparative Example 3 in which the main component of the adhesive is an acrylic resin, the peel strength after heat treatment is 1 (N/cm) in Example 3, while the peel strength after heat treatment is 0 (N/cm) in Comparative Example 3. These data are similar to each other. However, actually, in Comparative Example 3, the peel strength was 0 (N/cm) after 150 hours of heat treatment, while in Example 3, the peel strength was 7 (N/cm) after 150 hours of heat treatment. Thus, there is a difference between the two.

Under the heat treatment conditions 2 in which the heat treatment atmosphere is oil, when comparison is made between the examples in which Ni plating is performed and the comparative examples in which Ni plating is not performed and between the flexible printed circuit boards using the same adhesive (comparison between Example 1 and Comparative Example 1, and comparison between Example 2 and Comparative Example 2), in the case of any of the adhesives, the peel strength before heat treatment of the example is at the same level as that of the comparative example, but the peel strength after heat treatment of the example is higher than that of the comparative example. The reason for this is believed to be that leakage of copper from the copper foil and permeation of components reactive with copper into the copper foil are prevented by the shielding layer.

Under the heat treatment conditions 3 in which the heat treatment atmosphere is oil mist, the same results as those under the heat treatment conditions 2 are obtained. The reason for this is believed to be that, as in the case of the heat treatment conditions 2, leakage of copper from the copper foil and permeation of components reactive with copper into the copper foil are prevented by the shielding layer.

On the basis of the examples described above, it is considered that the long-term heat resistance and oil resistance of the flexible printed circuit board can be increased by the shielding layer.

### Industrial Applicability

The present invention can be suitably applied to, for example, substrates for a flexible printed circuit board and flexible printed circuit boards in which long-term heat resistance and oil resistance are required.

### Reference Signs List

1, 101 flexible printed circuit board
2, 102 base film
3 conductive pattern
4, 104 adhesive layer
5, 105 protective film
6, 106 shielding layer
9, 109 copper foil
10 adhesive layer for the base film

## Claims

1. A substrate for a flexible printed circuit board **characterized by** comprising:
an insulating flexible base film;
a conductive pattern made of copper disposed on one or both surfaces of the base film; and
a shielding layer disposed on a surface of the conductive pattern, the shielding layer preventing leakage of copper or permeation of components reactive with copper.

2. A substrate for a flexible printed circuit board **characterized by** comprising:
an insulating flexible base film;
a conductive pattern made of copper disposed on one or both surfaces of the base film with an adhesive layer for the base film therebetween; and
a shielding layer on a surface of the conductive pattern on the side in contact with the adhesive layer for the base film, the shielding layer preventing leakage of copper or permeation of components reactive with copper.

3. The substrate for a flexible printed circuit board according to Claim 2, further comprising a shielding layer on another surface of the conductive pattern, the shielding layer preventing leakage of copper or permeation of components reactive with copper.

4. A flexible printed circuit board comprising:
the substrate for a flexible printed circuit board according to Claim 1, 2, or 3; and
a protective film disposed on a surface side of the conductive pattern with an adhesive layer therebetween.

5. The flexible printed circuit board according to Claim 4, wherein, after the flexible printed circuit board is left to stand in automatic transmission fluid (ATF) oil mist at 150°C for 1,000 hours, the peel strength between the protective film and the conductive pattern is 2 (N/cm) or more.

6. The flexible printed circuit board according to Claim 4, wherein, after the flexible printed circuit board is left to stand in ATF oil at 150°C for 1,000 hours, the peel strength between the protective film and the conductive pattern is 2 (N/cm) or more.

7. The flexible printed circuit board according to Claim 4, wherein, after the flexible printed circuit board is subjected to heat treatment in air at 150°C for 1,000 hours, the peel strength between the protective film and the conductive pattern is 70% or more of the peel strength before the heat treatment.

8. The substrate for a flexible printed circuit board according to Claim 1, 2, or 3, wherein the main component of the shielding layer is nickel (Ni), tin (Sn), or aluminum (Al).

9. The substrate for a flexible printed circuit board according to Claim 1, 2, or 3, wherein the shielding layer is formed by a plating on the surface of the conductive pattern.

10. The substrate for a flexible printed circuit board according to Claim 1, 2, or 3, wherein the average thickness of the shielding layer is 0.01 to 6.0 µm.

11. The flexible printed circuit board according to any one of Claims 4 to 7, wherein the main component of an adhesive constituting the adhesive layer is a polyimide resin.

12. A method for manufacturing a substrate for a flexible printed circuit board comprising a step of forming a substrate which includes an insulating flexible base film, a conductive pattern made of copper disposed on one or both surface sides of the base film, and a shielding layer disposed on a surface of the conductive pattern, the shielding layer preventing leakage of copper or permeation of components reactive with copper.
